# EUROPEAN PATENT SPECIFICATION

(11) **EP 3 885 548 B1**
(45) Date of publication and mention of the grant of the patent: **20.12.2023**
(21) Application number: 21157265.6
(22) Date of filing: 16.02.2021
(51) Int. Cl.: F02B 29/04, F02M 26/04, F02M 26/06, F02M 26/22, F01P 3/20, F01P 7/14, F01P 7/16, B60K 6/40, B60K 6/48, B60K 1/00

(54) **VEHICLE WITH COOLING DEVICE**
FAHRZEUG MIT KÜHLVORRICHTUNG
VÉHICULE AVEC DISPOSITIF DE REFROIDISSEMENT

(30) Priority: 25.03.2020 JP 2020054595
(43) Date of publication of application: 29.09.2021
(73) Proprietor: MAZDA MOTOR CORPORATION, Hiroshima 730-8670 (JP)
(72) Inventor: HIKITANI, Shinichi, Fuchu-cho, Aki-gun,, Hiroshima 730-8670 (JP); NAGANO, Naoki, Fuchu-cho, Aki-gun,, Hiroshima 730-8670 (JP); YAMASHITA, Yoshiyuki, Fuchu-cho, Aki-gun,, Hiroshima 730-8670 (JP); JO, Yukio, Fuchu-cho, Aki-gun,, Hiroshima 730-8670 (JP); YAMAGA, Yuma, Fuchu-cho, Aki-gun,, Hiroshima 730-8670 (JP)
(74) Representative: Müller-Boré & Partner Patentanwälte PartG mbB

(56) References cited:
- EP-A1- 3 128 146
- EP-A1- 3 530 915
- WO-A1-2015/010540
- DE-A1-102018 002 584
- US-A1- 2019 375 270

## Description

### TECHNICAL FIELD

The present disclosure relates to a vehicle provided with an engine having an exhaust gas recirculation (EGR) system, a supercharger, and an intercooler.

### BACKGROUND OF THE DISCLOSURE

Conventionally, it is known that a circuit has a channel through which coolant for cooling an engine as a power source of a vehicle flows, a channel through which coolant for cooling a motor drive having an electric motor as a power source and its high-voltage components flows, and a channel through which oil for lubricating inside a transmission flows. The circuit exchanges heat between the coolant for cooling the motor drive and the oil for lubricating inside the transmission (e.g., JP2015-001301A).

Here, engines with a supercharger (a turbocharger, a mechanical supercharger, etc.) need to be provided with the supercharger and an intercooler for cooling intake gas containing intake air (fresh air) and EGR gas in order to improve the engine output. If a cooling passage for coolant for cooling a motor drive is branched to the intercooler in order to improve the cooling efficiency of intake gas by the intercooler, the intake gas containing the EGR gas may be cooled to generate condensed water.

DE 10 2018 002584 A1 relates to an internal combustion engine for a motor vehicle, with a crankcase forming at least one combustion chamber of the internal combustion engine and through which a coolant can flow for cooling the crankcase.

US 2019/375270 A1 describes that a thermal management system for a vehicle may include a refrigerant circuit in which a refrigerant circulates, as well as a heating circuit.

EP 3 128 146 A1 describes that a cooling system for a hybrid vehicle comprises an indirect charge air cooler and an electro-cooler, the charge air cooler and the electro-cooler each in fluid communication with a common low temperature radiator.

EP 3 530 915 A1 describes that an engine includes an EGR device and a water-cooled heat exchanger. The water-cooled heat exchanger is provided on a downstream side of an EGR gas-introduction portion of an intake passage into which EGR gas is to be introduced and exchanges heat with gas flowing in the intake passage.

### SUMMARY OF THE DISCLOSURE

Therefore, the present disclosure is made in view of solving the problem described above, and one purpose thereof is to suppress an excessive cooling of intake gas containing exhaust gas recirculation (EGR) gas circulating inside the intercooler and can suppress the generation of condensed water.

The above problem is solved by the invention as defined in claim 1.

According to the invention, the coolant channel is provided with the second channel which branches from the first channel cooling components, and through which the second coolant cooling the intercooler flows. The second channel is provided with the valve which can adjust the flow rate of the second coolant. This valve adjusts the flow rate of the second coolant according to the temperature of the coolant, the excessive cooling of the intake gas including EGR gas which circulates inside the intercooler cooled by the second coolant can be suppressed, and therefore, the generation of the condensed water can be suppressed.

According to the invention, since the valve reduces the flow rate of the second coolant for cooling the intercooler when the intake gas temperature at the outlet of the intercooler is below the given temperature rather than the flow rate when the intake gas temperature exceeds the given temperature, the excessive cooling of the intake gas which circulates inside the intercooler can be suppressed, and therefore, the generation of the condensed water can be suppressed.

The controller may control the valve when the intake gas temperature at the outlet of the intercooler is below a given second temperature lower than the given temperature so that the flow rate of the second coolant becomes zero. According to this configuration, since the valve makes the flow rate of the second coolant for cooling the intercooler zero when the intake gas temperature at the outlet of the intercooler is below the given second temperature which is lower than the given temperature, the excessive cooling of the intake gas which circulates inside the intercooler can be suppressed more effectively.

The cooling device may further include a coolant channel for the engine through which coolant for cooling the engine flows. The first channel and the second channel of the coolant channel may be independent from the coolant channel for the engine. According to this configuration, since the first channel for cooling the high-voltage component of the motor drive and the second channel for cooling the intercooler are provided as the separate circuits which are independent from the coolant channel for the engine, the second channel can cool the intercooler by the comparatively cold coolant, without being influenced by the comparatively hot coolant which circulates inside the engine. Thus, the excessive cooling of the intake gas which circulates inside the intercooler can be suppressed more effectively.

The controller may determine whether the intake gas temperature at the outlet of the intercooler is below a given first temperature. When the intake gas temperature is determined to exceed the given first temperature, the controller may control the valve to be fully opened. When the intake gas temperature is determined to be below the given first temperature, the controller may determine whether the intake gas temperature is below a given second temperature lower than the given first temperature. When the intake gas temperature is determined to exceed the given second temperature, the controller may control the flow regulating valve so that the flow rate of the coolant circulating the second channel and the intercooler becomes a second coolant flow rate smaller than a coolant flow rate when the flow regulating valve is fully opened.

When the intake gas temperature is determined to be below the given second temperature, the controller may control the flow regulating valve to be closed so that the flow rate of the coolant circulating the second channel and the intercooler becomes zero.

### BRIEF DESCRIPTION OF DRAWINGS

Fig. 1 is a plan view schematically illustrating a configuration of a power source and a power transmission mechanism of a vehicle to which a cooling device according to a first embodiment of the present disclosure is applied.
Fig. 2 is a view schematically illustrating a configuration of a heat-exchange circuit for coolant and oil of the cooling device according to the first embodiment of the present disclosure.
Fig. 3 is a control block diagram illustrating a controller of the cooling device according to the first embodiment of the present disclosure.
Fig. 4 is a flowchart illustrating a control processing executed by the controller of the cooling device according to the first embodiment of the present disclosure.
Fig. 5 is a time chart illustrating a relationship between a temporal change in an intake gas temperature at an intercooler outlet and a temporal change in a coolant flow rate, which are controlled by the controller of the cooling device according to the first embodiment of the present disclosure.
Fig. 6 is a plan view schematically illustrating a configuration of a power source and a power transmission mechanism of a vehicle to which a cooling device according to a second embodiment of the present disclosure is applied.
Fig. 7 is a view schematically illustrating a configuration of a heat-exchange circuit for coolant and oil of the cooling device according to the second embodiment of the present disclosure.

### DETAILED DESCRIPTION OF THE DISCLOSURE

Hereinafter, cooling devices for a vehicle according to embodiments of the present disclosure will be described with reference to the accompanying drawings. All of the features as shown in the drawings may not necessarily be essential.

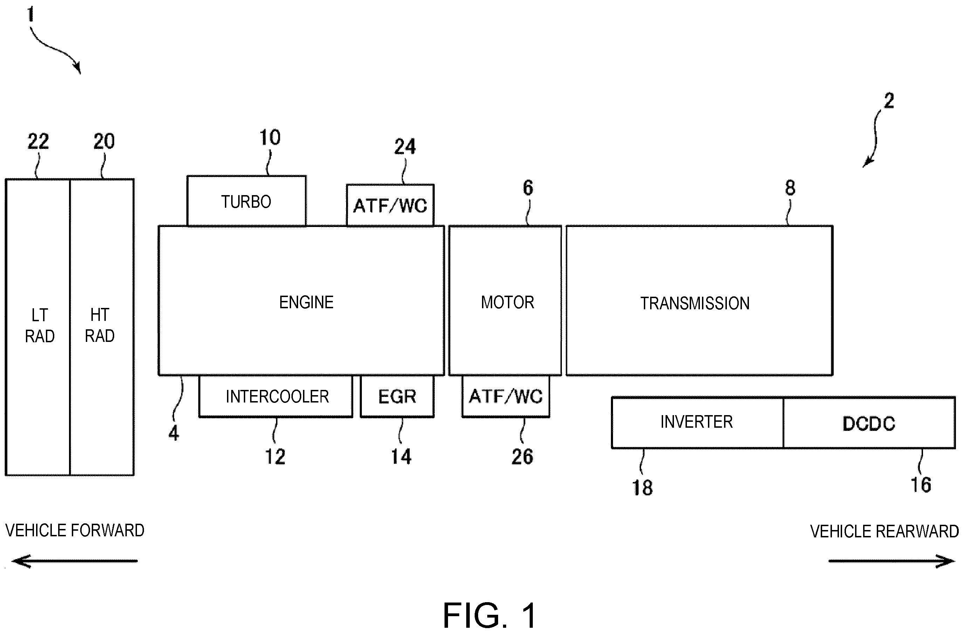

First, referring to Fig. 1, an outline configuration of a power transmission system of a vehicle to which a cooling device according to a first embodiment of the present disclosure is applied is described. Fig. 1 is a plan view schematically illustrating a configuration of a power source and a power transmission mechanism of the vehicle to which the cooling device according to the first embodiment of the present disclosure is applied.

As illustrated in Fig. 1, a power transmission system 2 to which the cooling device 1 according to the first embodiment of the present disclosure is applied includes an engine 4 and a motor (or an electric motor) 6 which are power sources, and a transmission 8 which is a power transmission device. In this embodiment, although the engine 4 is a multi-cylinder (six cylinders) longitudinal engine, it may have any number of cylinders (e.g., four cylinders).

The vehicle according to this embodiment is a front-engine rear-wheel-drive (FR) vehicle where the motor 6 is provided between the engine 4 and the transmission 8, and the transmission 8 is a longitudinal transmission provided rearward of the motor 6. The power of the engine 4 and/or the motor 6 is transmitted to the transmission 8, and it is transmitted to rear wheels (not illustrated) through a propeller shaft and a differential device (not illustrated). Although the transmission 8 is an automatic transmission, it may be a manual transmission. Note that the cooling device 1 according to this embodiment of the present disclosure may be also applicable to a front-wheel-drive vehicle having a power transmission system (not illustrated) with a transverse engine and a transverse transmission, as a modification.

Next, as illustrated in Fig. 1, the engine 4 of the power transmission system 2 according to this embodiment includes a supercharger (particularly a turbocharger) 10, an intercooler 12 for cooling intake gas containing intake air (fresh air) and exhaust gas recirculation (EGR) gas, and an EGR system 14 which circulates exhaust gas to the intake side. In this embodiment, although the supercharger 10 is a turbocharger which utilizes exhaust pressure, it may be an electric turbocharger or a mechanical supercharger.

Moreover, the motor 6 of the power transmission system 2 according to this embodiment is connected to a DC-DC converter (a voltage converter or a potential transformer) 16 and an inverter 18 which are high-voltage components for actuating the motor 6, and the motor 6 and the high-voltage components 16 and 18 constitute a motor drive.

Forward of the engine 4 and the motor 6, an air-cooled radiator 20 for high-temperature coolant (HT radiator) (hereinafter, a first radiator) which cools coolant circulating through the engine 4 to cool the engine 4 by using traveling wind (an air flow caused by the vehicle traveling), and an air-cooled radiator 22 for low-temperature coolant (LT radiator) (hereinafter, a second radiator) provided forward of the first radiator 20 and which cools coolant circulating and cooling the DC-DC converter 16, the inverter 18 and the motor 6, and the intercooler 12 by the traveling wind, are provided. Each of the radiators 20 and 22 is a heat exchanger which carries out a heat exchange between the traveling wind and the coolant.

Moreover, as illustrated in Fig. 1, a first heat exchanger (Automatic Transmission Fluid / Warmer-Cooler) 24 described later which exchanges heat between the engine coolant and transmission oil is attached to the engine 4, and a second heat exchanger (Automatic Transmission Fluid / Warmer-Cooler) 26 described later which exchanges heat between motor drive coolant and the transmission oil is attached to the motor 6.

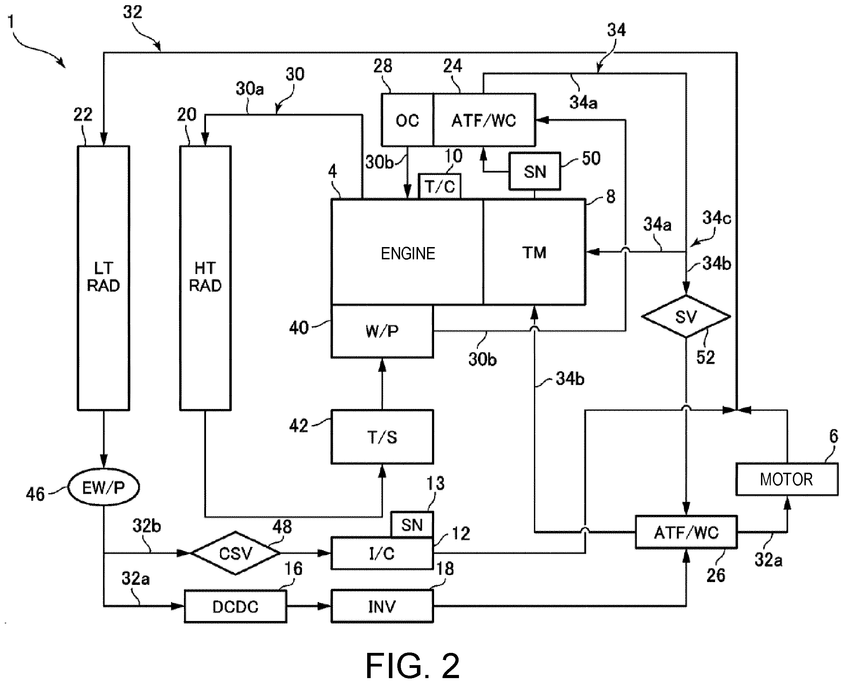

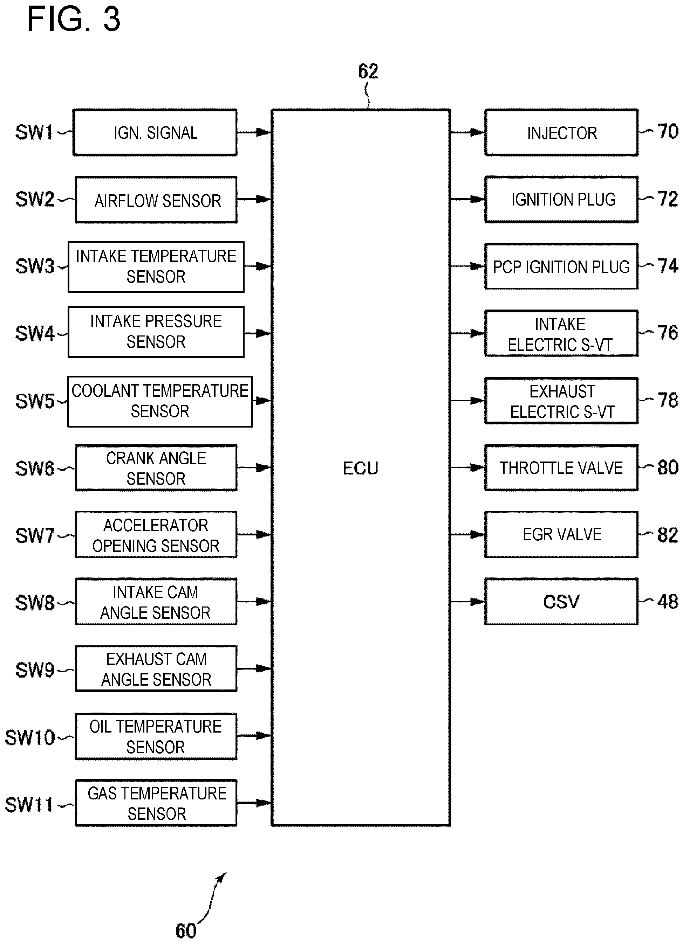

Next, an outline configuration of a heat-exchange circuit for the coolant and the oil including the coolant channel, the oil channel, and the heat exchangers of the cooling device for the vehicle according to the first embodiment of the present disclosure is described with reference to Figs. 2 and 3. Fig. 2 is a view schematically illustrating the outline configuration of the heat-exchange circuit for the coolant and the oil of the cooling device according to the first embodiment of the present disclosure, and Fig. 3 illustrates charts of one example of a concept of adjustment of an oil flow rate by an oil flow rate adjuster of the cooling device according to the first embodiment of the present disclosure. First, as illustrated in Fig. 2, the cooling device 1 according to the first embodiment of the present disclosure mainly includes three channels/circuits comprised of a coolant channel 30 for the engine (hereinafter, a first coolant channel), a coolant channel 32 for the motor drive (hereinafter, a second coolant channel), and an oil channel 34 for the transmission (hereinafter, an oil channel).

The first coolant channel 30 is a channel for coolant which circulates and cools the engine 4 and an oil cooler (OC) 28 which cools engine oil inside the engine 4. Here, the engine 4 has the supercharger 10 described above, and bearings of the supercharger 10 are lubricated with engine oil, and the first coolant channel 30 does not pass through the supercharger 10. The second coolant channel 32 is a channel for coolant which circulates and cools the DC-DC converter (DCDC) 16, the inverter (INV) 18 and the motor (MOTOR) 6, and the intercooler 12 (I/C). The intercooler 12 is to cool intake gas containing intake air (fresh air) and EGR gas which is compressed by the supercharger 10 and fed into combustion chambers (not illustrated) of the engine 4, and the intercooler 12 is provided with an intake-gas temperature sensor 13 which detects a temperature of the intake gas at an outlet of the intercooler 12. The oil channel 34 is a channel for the transmission oil which lubricates inside the transmission (TM) 8.

The first coolant channel 30 is described in more detail. The first coolant channel 30 is provided with a water pump 40 which circulates coolant inside the first coolant channel 30. The first coolant channel 30 has two branched channels. First, the first coolant channel 30 has a first channel 30a where coolant circulates through the water pump 40, the engine 4, the first radiator 20, and a thermostat (T/S) 42 as a thermoregulator of the coolant, in this order. The thermostat 42 is a valve which opens when the coolant circulating through the engine 4 is hot enough to be cooled by the radiator 20 so that the coolant circulates through the radiator 20.

The first coolant channel 30 further has a second channel 30b where coolant circulates through the water pump 40, the first heat exchanger 24, the oil cooler 28, and the engine 4, in this order. The first heat exchanger 24 exchanges heat between the coolant which flows through the second channel 30b and the oil (transmission oil) which flows through the oil channel 34.

Next, the second coolant channel 32 is described in more detail. The second coolant channel 32 is provided with a water pump 46 for circulating coolant inside the second coolant channel 32. The second coolant channel 32 has two branched channels. First, the second coolant channel 32 has a first channel 32a where coolant circulates through the water pump 46, the DC-DC converter 16, the inverter 18, the second heat exchanger 26, and the motor 6, in this order. The second heat exchanger 26 exchanges heat between the coolant which flows through the first channel 32a and the oil which flows through the oil channel 34.

Further, the second coolant channel 32 has a second channel 32b which branches from the first channel 32a, joins the first channel 32a at a location downstream of the motor 6. The second channel 32b allows the coolant to circulate through a flow regulating valve / coolant solenoid valve 48 which adjusts a flow rate of the coolant of the second channel 32b, and the intercooler 12, in this order. The flow regulating valve (CSV) 48 is an electromagnetic solenoid valve, and is changeable of a duty ratio by an On-Off control to adjust an opening of this valve.

Next, the oil channel 34 is described in more detail. The transmission 8 is provided with an oil pump (not illustrated) which circulates oil inside the transmission 8 and the oil channel 34. The oil pump (not illustrated) is a known oil pump which supplies transmission oil as lubricant / hydraulic fluid to power transmission components inside the transmission 8 (gears, clutches, etc.).

The oil channel 34 has two branched channels. First, the oil channel 34 has a first channel 34a which circulates oil between the transmission 8 and the first heat exchanger 24. This first channel 34a is also a channel which bypasses the second heat exchanger 26. Further, the oil channel 34 has a second channel 34b which branches at a branch part 34c from the first channel 34a, and circulates the oil which circulated through the transmission 8 and the first heat exchanger 24 to the second heat exchanger 26, and circulates it from the second heat exchanger 26 to the transmission 8.

Moreover, the oil channel 34 is provided with an oil temperature sensor (SN) 50 which detects temperature of the oil. This oil temperature sensor 50 may be provided at any location of the oil channel 34, as long as it can detect the temperature of the oil.

Moreover, a solenoid valve device (SV) 52 which adjusts a flow rate of oil which flows into the second heat exchanger 26 is provided to the second channel 34b of the oil channel 34. The solenoid valve device 52 is an electromagnetic solenoid valve, and is capable of adjusting an opening of the valve by an On-Off control which changes a duty ratio. In this embodiment, the solenoid valve device 52 is configured so that it adjusts its opening to adjust a flow rate of oil which circulates through the first heat exchanger 24 (first oil flow rate) and a flow rate of oil which circulates through the second heat exchanger 26 (second oil flow rate).

For example, the solenoid valve device 52 makes the first oil flow rate larger than the second oil flow rate when the oil temperature is below a given temperature (e.g., 80°C or about 80°C), and on the other hand, it makes the first oil flow rate smaller than the second oil flow rate when the oil temperature exceeds the given temperature. Note that as one modification, when the oil temperature exceeds the given temperature, it may set so that the first oil flow rate becomes equal to the second oil flow rate. Moreover, the second oil flow rate when exceeding the given temperature may be larger than the second oil flow rate when below the given temperature.

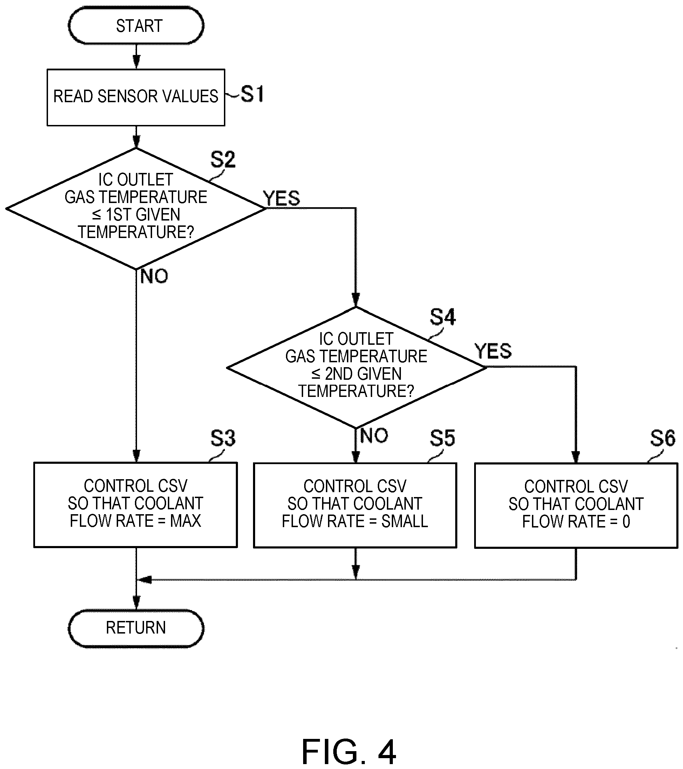

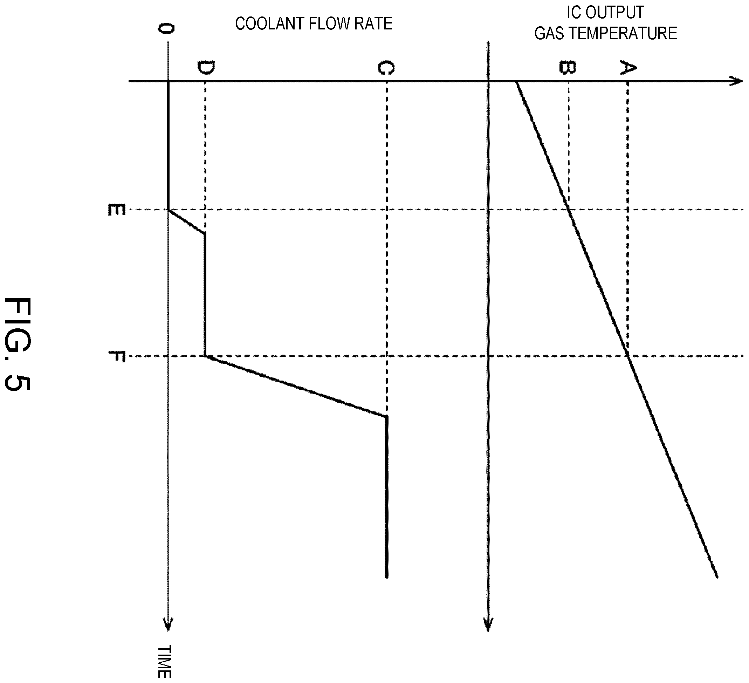

Next, a control procedure of the flow regulating valve 48 in the cooling device according to the first embodiment of the present disclosure is described with reference to Figs. 3 to 5. Fig. 3 is a control block diagram of the controller of the cooling device according to the first embodiment of the present disclosure. Fig. 4 is a flowchart illustrating a control processing executed by the controller of the cooling device according to the first embodiment of the present disclosure. Fig. 5 is a time chart illustrating a relationship between a temporal change in a coolant flow rate controlled by the controller of the cooling device according to the first embodiment of the present disclosure, and a temporal change in an intake gas temperature at the intercooler outlet. First, a control block of the control system provided to the cooling device 1 according to the first embodiment of the present disclosure is described with reference to Fig. 3. As illustrated in Fig. 3, a control system 60 of the cooling device 1 according to this embodiment is provided with an ECU 62 (controller) which controls the flow regulating valve 48, etc.

In this embodiment, an output signal related to temperatures of intake gas at the intercooler outlet from the intake-gas temperature sensor 13 (SW11) which is provided to the intercooler 12 as described above, is inputted into the ECU 62. The ECU 62 controls the flow regulating valve 48 based on the output signal from the intake-gas temperature sensor 13 (SW11), as describe later, to control a flow rate of the coolant which circulates inside the intercooler 12.

Moreover, in this embodiment, an output signal related to the temperature of the coolant in the second coolant channel 32 from a coolant temperature sensor SW5 (not illustrated in Figs. 1 and 2) provided at downstream of the radiator 22 in the second coolant channel 32, and an output signal related to the temperature of the oil in the oil channel 34 from the oil temperature sensor 50 (SW10) which is provided downstream of the transmission 8 in the oil channel 34 are inputted into the ECU 62. The ECU 62 controls the opening of the solenoid valve 52 based on these output signals to control the flow rate of the oil in the second channel 34b of the oil channel 34 to control the flow rate of the oil which circulates through the second heat exchanger 26.

Note that an ignition output signal which means a command for an engine start (SW1), an output signal related to an intake air amount from an airflow sensor SW2 provided to the intake passage of the engine 4, an output signal related to an intake-air temperature from an intake air temperature sensor SW3 provided to the intake passage, an output signal related to an intake pressure from an intake pressure sensor SW4 provided to the intake passage, an output signal related to a crank angle from a crank angle sensor SW6 provided to the crankshaft (4a) of the engine 4, an output signal related to an opening of an accelerator pedal from an accelerator opening sensor SW7, an output signal related to a cam angle at the intake side from an intake cam angle sensor SW8 provided to an intake cam shaft (not illustrated), and an output signal related to a cam angle at the exhaust side from an exhaust cam angle sensor SW9 provided to an exhaust cam shaft (not illustrated) are inputted into the ECU 62. Based on the ignition signal (SW1) and the output signals from the various sensors SW2-SW9, the ECU 62 controls a fuel injection timing by controlling an injector 70 of the engine 4, controls an ignition timing by controlling an ignition plug 72 and an auxiliary chamber ignition plug (PCP) 74, controls an air-fuel ratio by controlling a throttle valve 80, a variable valve lift mechanism at the intake side (intake electric S-VT) 76, and/or the injector 70, and controls a flow rate of EGR gas which recirculates to the intake side of the engine 4 by controlling a variable valve lift mechanism at the exhaust side (exhaust electric S-VT) 78 and an EGR valve 82.

Next, a procedure of a control processing executed by the controller (ECU) of the cooling device 1 according to the first embodiment of the present disclosure is described with reference to Figs. 4 and 5. As illustrated in Fig. 4, the ECU 62 first reads the output signals (sensor values) of the various sensors at Step S1. In this embodiment, the output signal related to the temperature of the intake gas at the outlet of the intercooler 12 from the intake-gas temperature sensor 13 (SW11) is inputted.

Next, the ECU 62 shifts to Step S2 where it determines whether the gas temperature at the intercooler outlet (IC outlet) read at Step S1 is below a given first temperature A (see Fig. 5). If the ECU 62 determines at Step S2 that the gas temperature exceeds the given first temperature A (NO at Step S2), the ECU 62 shifts to Step S3 where it controls to fully open the flow regulating valve (CSV) 48 so that a flow rate of coolant which circulates to the second channel 32b of the second coolant channel 32 and the intercooler 12 becomes a maximum flow rate C (see Fig. 5) at which the water pump 46 is capable of sending out. In this embodiment, for example, the given first temperature A is 50°C or less, and the maximum flow rate C (first coolant flow rate) in the second channel 32b is 10 to 20L/min.

Next, if the ECU 62 determines at Step S2 that the gas temperature at the intercooler outlet is below the given first temperature A (YES at Step S2), the ECU 62 shifts to Step S4 where it determines whether the gas temperature at the intercooler outlet is below a given second temperature B which is lower than the given first temperature A. If the ECU 62 determines at Step S4 that the gas temperature exceeds the given second temperature B (NO at Step S4), the ECU 62 shifts to Step S5 where it controls the flow regulating valve 48 so that a flow rate of coolant which circulates to the second channel 32b and the intercooler 12 becomes a second coolant flow rate D (see Fig. 5) which is smaller than the maximum flow rate. In this embodiment, by such a control, an excessive cooling of the intake gas which circulates inside the intercooler 12 is suppressed. In this embodiment, for example, the given second temperature B is 30°C or less, and the second coolant flow rate D in the second channel 32b (second coolant flow rate) is 2 to 5L/min. In this embodiment, the second coolant flow rate D is set at a small quantity which is 20% to 25% of the maximum coolant flow rate C.

Next, if the ECU 62 determines at Step S4 that the gas temperature is below the given second temperature B (YES at Step S4), the ECU 62 shifts to Step S6 where it controls to close the flow regulating valve 48 so that the flow rate of the coolant which circulates to the second channel 32b and the intercooler 12 becomes zero (see Fig. 5). In this embodiment, by such a control, the excessive cooling of the intake gas which circulates inside the intercooler 12 is suppressed.

As illustrated by the time chart in Fig. 5, for example, if a timing of a cold start of the engine 4 and the motor 6 is set as Time=0, since the temperature of the intake gas at the outlet of the intercooler 12 is fundamentally below the given second temperature B, the flow regulating valve (CSV) 48 is controlled so that the flow rate of the coolant which circulates inside the intercooler 12 becomes zero. At this time, the excessive cooling of the intake gas which circulates inside the intercooler 12 is suppressed. Then, when the coolant temperature of the second coolant channel 32 rises by the operation of the motor drives 6, 16, and 18, and the temperature of intercooler 12 rises accordingly, the intake gas temperature at the intercooler outlet also rises and it exceeds the given second temperature B (at Time E in Fig. 5). Thus, when the intake gas temperature exceeds the given second temperature B, the flow regulating valve (CSV) 48 is controlled so that the flow rate of the coolant which circulates inside the intercooler 12 becomes the second coolant flow rate D which is a small rate. At this time, the excessive cooling of the intake gas which circulates inside the intercooler 12 is suppressed. Then, when it becomes Time F at which the intake gas temperature at the intercooler outlet exceeds the given first temperature A, the flow regulating valve (CSV) 48 is controlled so that the flow rate of the coolant which circulates inside the intercooler 12 becomes the first coolant flow rate C which is the maximum flow rate.

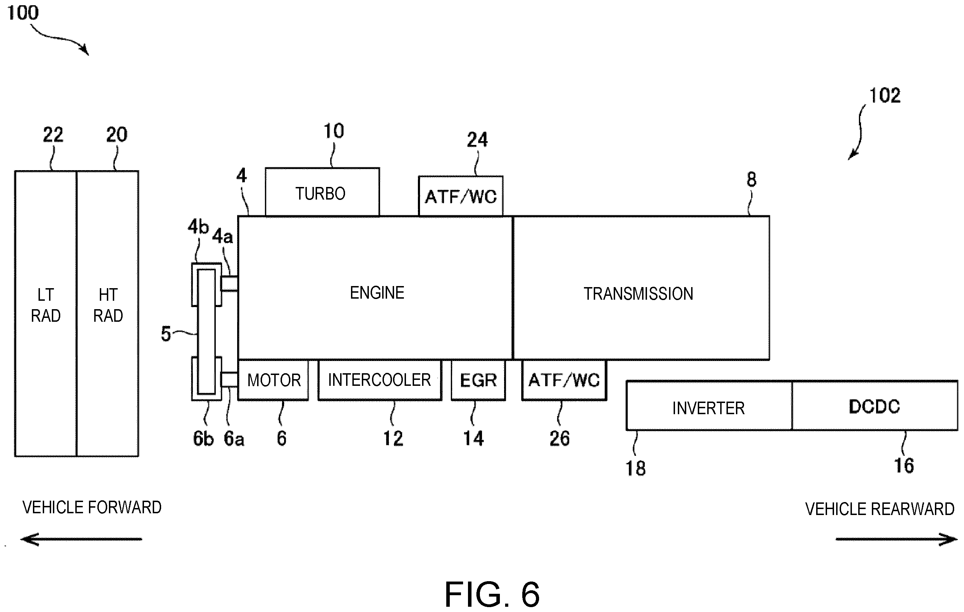

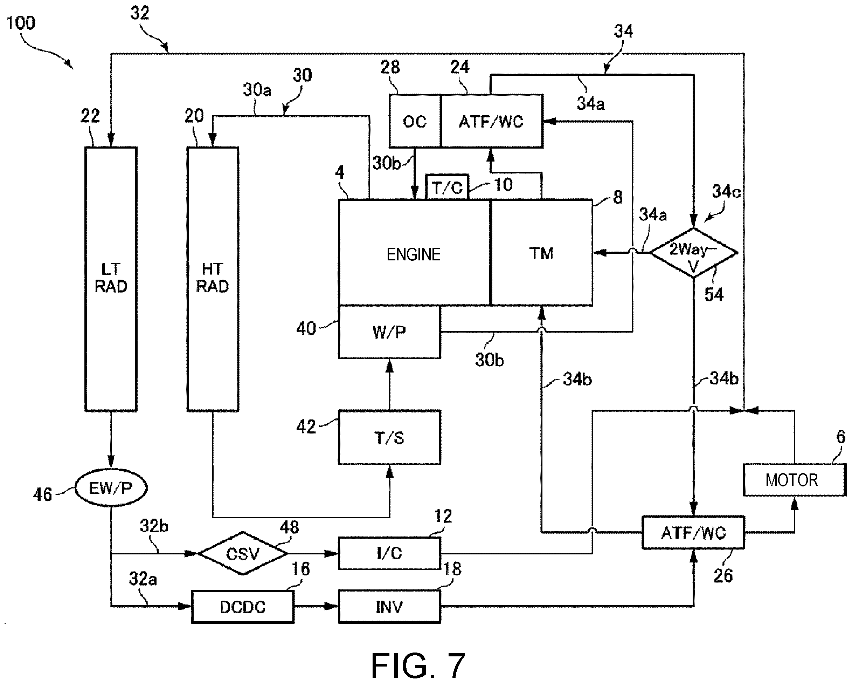

Next, a cooling device according to a second embodiment of the present disclosure is described with reference to Figs. 6 and 7. Fig. 6 is a plan view illustrating an outline configuration of a power source and a power transmission mechanism of a vehicle to which the cooling device according to the second embodiment of the present disclosure is applied. Fig. 7 is a view schematically illustrating an outline configuration of a heat-exchange circuit for coolant and oil of the cooling device according to the second embodiment of the present disclosure. Below, a configuration different from the first embodiment is mainly described. As for the configuration of the second embodiment, the same reference characters are assigned to the same components with the first embodiment, even though the components are different in layout.

First, as illustrated in Fig. 6, a power transmission system 102 to which a cooling device 100 according to the second embodiment of the present disclosure is applied includes, similarly to the first embodiment, the engine 4 and the motor 6 which are the power sources, the transmission 8, the supercharger 10, the intercooler 12, the EGR system 14, the DC-DC converter 16, the inverter 18, the air-cooled radiator 20 for high-temperature coolant (first radiator), the air-cooled radiator 22 for low-temperature coolant (second radiator), the first heat exchanger 24, and the second heat exchanger 26.

In the second embodiment, as illustrated in Fig. 6, the motor 6 is not disposed between the engine 4 and the transmission 8, but it is disposed in parallel with the engine 4 in the vehicle width direction. In the second embodiment, a power transmission belt 5 which connects a motor pulley 6b provided to an output shaft 6a of the motor with a crank pulley 4b provided to a crankshaft 4a of the engine 4 is provided, and a driving force of the motor 6 is transmitted to the crankshaft 4a through the belt 5. The power of the engine 4 and/or the motor 6 is/are transmitted to the transmission 8.

Next, as illustrated in Fig. 7, the cooling device 100 according to the second embodiment of the present disclosure mainly includes, similarly to the first embodiment, three channels/circuits comprised of the coolant channel 30 for the engine (first coolant channel) where coolant circulates and cools the engine 4 and the oil cooler 28, the coolant channel 32 for the motor drive (second coolant channel) where coolant circulates and cools the DC-DC converter 16, the inverter 18 and the motor 6, and the intercooler 12, and an oil channel 34 for the transmission (oil channel) where the transmission oil for lubricating inside the transmission 8 circulates.

The first coolant channel 30 is configured similarly to the first embodiment. That is, the first coolant channel 30 is provided with the water pump 40 and it has two branched channels. The first channel 30a of the first coolant channel 30 is a channel where coolant circulates through the water pump 40, the engine 4, the first radiator 20, and the thermostat 42, in this order, and the second channel 30b of the first coolant channel 30 is a channel where coolant circulates through the water pump 40, the first heat exchanger 24, the oil cooler 28, and the engine 4, in this order.

The second coolant channel 32 is configured similarly to the first embodiment. That is, the second coolant channel 32 is provided with the water pump 46, and it has two branched channels. The first channel 32a of the second coolant channel 32 is a channel where coolant circulates through the water pump 46, the DC-DC converter 16, the inverter 18, the second heat exchanger 26, and the motor 6, in this order, and the second channel 32b is a channel which branches from the first channel 32a, and joins the first channel 32a at a location downstream of the motor 6.

The oil channel 34 according to the second embodiment has, similarly to the first embodiment, a first channel 34a which circulates oil between the transmission 8 and the first heat exchanger 24 by an oil pump (not illustrated) provided to the transmission 8, and a second channel 34b which branches from the first channel 34a and which circulates the oil circulated through the transmission 8 and the first heat exchanger 24 to the second heat exchanger 26.

The oil channel 34 according to the second embodiment is provided with a two-way valve (2Way-V) 54, instead of the solenoid valve device 52 of the first embodiment. In more detail, the oil channel 34 is further provided, at a branch part 34c where the second channel 34b branches from the first channel 34a, with the two-way valve 54 for fully separating the oil which flows through the first channel 34a from the oil which flows through the second channel 34b. The two-way valve 54 of the second embodiment is a so-called thermostat, and can adjust an oil flow rate which circulates through the first heat exchanger 24 (first oil flow rate) and an oil flow rate which circulates through the second heat exchanger 26 (second oil flow rate) by being opened and closed according to the oil temperature of the oil channel 34.

For example, when the oil temperature is below the given temperature (e.g., 80°C or about 80°C), the two-way valve 54 is closed so that the oil circulates only to the first heat exchanger 24, and on the other hand, when the oil temperature exceeds the given temperature, the two-way valve 54 is opened so that the oil circulates to both the first heat exchanger 24 and the second heat exchanger 26.

Next, main operation and effects of the cooling device according to this embodiment of the present disclosure are described. First, in the cooling devices 1 and 100 according to the first embodiment and the second embodiment of the present disclosure, since the coolant channel 32 is provided with the second channel 32b which branches from the first channel 32a for cooling the high-voltage components 16 and 18 and through which the coolant for cooling the intercooler 12 circulates, and the second channel 32b is provided with the adjuster (CSV) 48 which can adjust the flow rate of the coolant, the adjuster 48 can adjust the flow rate of the coolant according to the temperature of the coolant, the excessive cooling of the intake gas including EGR gas which circulates inside the intercooler 12 and is cooled by the coolant can be suppressed, and therefore, the generation of the condensed water can be suppressed.

Moreover, according to the first and second embodiments, since the adjuster 48 reduces the flow rate of the coolant for cooling the intercooler 12 when the intake gas temperature at the outlet of the intercooler 12 is below the given temperature A rather than the flow rate when the intake gas temperature exceeds the given temperature A, the excessive cooling of the intake gas which circulates inside the intercooler 12 can be suppressed, and therefore, the generation of the condensed water can be suppressed.

Moreover, according to the first embodiment, since the adjuster 48 makes the flow rate of the coolant for cooling the intercooler 12 zero when the intake gas temperature at the outlet of the intercooler 12 is below the given second temperature B which is lower than the given temperature A, the excessive cooling of the intake gas which circulates inside the intercooler 12 can be suppressed.

Moreover, according to the first and second embodiments, since the first channel 32a for cooling the high-voltage components 16 and 18 and the second channel 32b for cooling the intercooler 12 are provided as the separate circuits which are independent from the coolant channel 30 for the engine 4, they can cool the intercooler 12 by the comparatively cold coolant, without being influenced by the comparatively hot coolant which circulates inside the engine 4.

It should be understood that the embodiments herein are illustrative and not restrictive, since the scope of the invention is defined by the appended claims rather than by the description preceding them.

### DESCRIPTION OF REFERENCE CHARACTERS

- 1, 100: Cooling Device
- 2, 102: Power Transmission System
- 4: Engine
- 6: Motor (Motor Drive)
- 8: Transmission
- 10: Supercharger
- 12: Intercooler
- 13, SW11: Intake-Gas Temperature Sensor
- 14: EGR System
- 16: DC-DC Converter (High-voltage Component, Motor Drive)
- 18: Inverter (High-voltage Component, Motor Drive)
- 20: Radiator for Engine Coolant (First Radiator)
- 22: Radiator for Motor Drive (Second Radiator)
- 24: First Heat Exchanger
- 26: Second Heat Exchanger
- 30: Coolant Channel for Engine
- 30a: First Channel of Coolant Channel for Engine
- 30b: Second Channel of Coolant Channel for Engine
- 32: Coolant Channel for Motor Drive (Coolant Channel)
- 32a: First Channel of Coolant Channel for Motor Drive (First Channel)
- 32b: Second Channel of Coolant Channel for Motor Drive (Second Channel)
- 34: Oil Channel for Transmission
- 34a: First Channel of Oil Channel for Transmission
- 34b: Second Channel of Oil Channel for Transmission
- 48: Flow Regulating Valve / Coolant Solenoid Valve (Valve)
- 50: Oil Temperature Sensor
- 52: Solenoid Valve
- 54: Two-way Valve
- 62: ECU (Controller)

## Claims

1. A vehicle comprising:
an engine (4) having an exhaust gas recirculation system (14), a supercharger (10), and an intercooler (12) configured to cool intake gas containing EGR gas; and
a cooling device (1, 100),
the cooling device (1, 100) comprising:
a coolant channel (32) through which coolant cooling a motor drive (6, 16, 18) flows, the coolant channel (32) having a first channel (32a) through which a first coolant cooling components (16, 18) of the motor drive (6, 16, 18) flows and a second channel (32b) through which a second coolant cooling the intercooler (12) flows, the second channel (32b) being branched from the first channel (32a); and
a valve (48) provided to the second channel (32b) of the coolant channel (32) and configured to adjust a flow rate of the second coolant,
wherein
an electric motor (6) and the components (16, 18) constitute the motor drive (6, 16, 18),
the components (16, 18) of the motor drive (6, 16, 18) are a converter (16) and an inverter (18),
the first channel (32a) is a channel where coolant circulates through a water pump (46), the converter (16), the inverter (18), and the electric motor (6), in this order,
the second channel (32b) is connected to the first channel (32a) at a location between the components (16, 18) and the water pump (46),
the second channel (32b) is configured to join the first channel (32a) at a location downstream of the electric motor (6),
the vehicle further comprises a controller (62) configured to control the valve (48),
the controller (62) is configured to control the valve (48) so that a flow rate of the second coolant when an intake gas temperature at an outlet of the intercooler (12) is below a given temperature is lower than a flow rate of the second coolant when the intake gas temperature exceeds the given temperature,
the intercooler (12) is provided with a temperature sensor (13) configured to detect a temperature of the intake gas, and
the temperature sensor (13) is configured to detect a temperature of the intake gas at the outlet of the intercooler (12).

2. The vehicle of claim 1, wherein the controller (62) is configured to control the valve (48) so that the flow rate of the second coolant becomes zero when the intake gas temperature at the outlet of the intercooler (12) is below a given second temperature lower than the given temperature.

3. The vehicle of any one of the preceding claims, further comprising another coolant channel (30) for the engine (4) through which coolant for cooling the engine (4) flows.

4. The vehicle of claim 1 or 2, further comprising another coolant channel (30) for the engine (4) through which coolant for cooling the engine (4) flows, and which is independent from the first channel (32a) and the second channel (32b) of the coolant channel (32).

5. The vehicle of any one of the preceding claims, wherein the controller (62) is configured to:
determine whether the intake gas temperature at the outlet of the intercooler (12) is below a given first temperature;
when the intake gas temperature is determined to exceed the given first temperature, control the valve (48) to be fully opened;
when the intake gas temperature is determined to be below the given first temperature, determine whether the intake gas temperature is below a given second temperature lower than the given first temperature; and
when the intake gas temperature is determined to exceed the given second temperature, control the flow regulating valve (48) so that the flow rate of the coolant circulating through the second channel (32b) and the intercooler (12) becomes a second coolant flow rate smaller than a coolant flow rate when the flow regulating valve (48) is fully opened.

6. The vehicle of claim 5, wherein, when the intake gas temperature is determined to be below the given second temperature, the controller (62) is configured to control the flow regulating valve (48) to be closed so that the flow rate of the coolant circulating through the second channel (32b) and the intercooler (12) becomes zero.

7. The vehicle of any one of the preceding claims, wherein
the first channel (32a) is connected to the components (16, 18), and/or
the second channel (32b) is connected to the intercooler (12).

8. The vehicle of any one of the preceding claims, wherein
the components (16, 18) of the motor drive (6, 16, 18) are high-voltage components.

## Patentansprüche

1. Ein Fahrzeug, das Folgendes umfasst:
einen Verbrennungsmotor (4) mit einem Abgasrückführungssystem (14), einem Lader (10) und einem Ladeluftkühler (12), der so konfiguriert ist, dass er Einlassgas, das AGR-Gas enthält, kühlt; und
eine Kühlvorrichtung (1, 100),
wobei die Kühlvorrichtung (1, 100) Folgendes umfasst:
einen Kühlmittelkanal (32), durch den ein Kühlmittel strömt, das einen Motorantrieb (6, 16, 18) kühlt, wobei der Kühlmittelkanal (32) Folgendes aufweist: einen ersten Kanal (32a), durch den ein erstes Kühlmittel strömt, das Komponenten (16, 18) des Motorantriebs (6, 16, 18) kühlt, und einen zweiten Kanal (32b), durch den ein zweites Kühlmittel strömt, das den Ladeluftkühler (12) kühlt, wobei der zweite Kanal (32b) vom ersten Kanal (32a) abgezweigt ist; und
ein Ventil (48), das für den zweiten Kanal (32b) des Kühlmittelkanals (32) bereitgestellt wird und so konfiguriert ist, dass es eine Durchflussrate des zweiten Kühlmittels einstellt,
wobei
ein Elektromotor (6) und die Komponenten (16, 18) den Motorantrieb (6, 16, 18) bilden,
wobei die Komponenten (16, 18) des Motorantriebs (6, 16, 18) ein Konverter (16) und ein Inverter (18) sind,
der erste Kanal (32a) ein Kanal ist, in dem Kühlmittel durch eine Wasserpumpe (46), den Konverter (16), den Inverter (18) und den Elektromotor (6) in dieser Reihenfolge zirkuliert,
der zweite Kanal (32b) mit dem ersten Kanal (32a) an einer Stelle zwischen den Komponenten (16, 18) und der Wasserpumpe (46) verbunden ist,
der zweite Kanal (32b) dazu konfiguriert ist, sich an einer Stelle stromabwärts des Elektromotors (6) mit dem ersten Kanal (32a) zu verbinden,
das Fahrzeug ferner ein Steuergerät (62) umfasst, das zur Steuerung des Ventils (48) konfiguriert ist,
die Steuerung (62) dazu konfiguriert ist, das Ventil (48) so zu steuern, dass eine Durchflussrate des zweiten Kühlmittels, wenn eine Einlassgastemperatur an einem Auslass des Ladeluftkühlers (12) unter einer gegebenen Temperatur liegt, geringer ist als eine Durchflussrate des zweiten Kühlmittels, wenn die Einlassgastemperatur die gegebene Temperatur übersteigt,
der Ladeluftkühler (12) mit einem Temperatursensor (13) versehen ist, der dazu konfiguriert ist, eine Temperatur des Einlassgases zu erfassen, und wobei
der Temperatursensor (13) dazu konfiguriert ist, eine Temperatur des Einlassgases am Auslass des Ladeluftkühlers (12) zu erfassen.

2. Das Fahrzeug nach Anspruch 1, wobei das Steuergerät (62) dazu konfiguriert ist, das Ventil (48) so zu steuern, dass die Durchflussrate des zweiten Kühlmittels null wird, wenn die Einlassgastemperatur am Auslass des Ladeluftkühlers (12) unter einer gegebenen zweiten Temperatur liegt, die niedriger ist als die gegebene Temperatur.

3. Das Fahrzeug nach irgendeinem der vorstehenden Ansprüche, das ferner einen weiteren Kühlmittelkanal (30) für den Verbrennungsmotor (4) umfasst, durch den Kühlmittel zur Kühlung des Verbrennungsmotors (4) fließt.

4. Das Fahrzeug nach Anspruch 1 oder 2, das ferner einen weiteren Kühlmittelkanal (30) für den Verbrennungsmotor (4) umfasst, durch den Kühlmittel zur Kühlung des Verbrennungsmotors (4) fließt und der unabhängig vom ersten Kanal (32a) und vom zweiten Kanal (32b) des Kühlmittelkanals (32) ist.

5. Das Fahrzeug nach irgendeinem der vorstehenden Ansprüche, wobei das Steuergerät (62) konfiguriert ist, um Folgendes zu bewerkstelligen:
Feststellen, ob die Einlassgastemperatur am Auslass des Ladeluftkühlers (12) unter einer vorgegebenen ersten Temperatur liegt;
wenn festgestellt wird, dass die Einlassgastemperatur die vorgegebene erste Temperatur überschreitet, Steuern des Ventils (48), sodass es vollständig geöffnet wird;
wenn festgestellt wird, dass die Einlassgastemperatur unter der vorgegebenen ersten Temperatur liegt, Feststellen, ob die Einlassgastemperatur unter einer vorgegebenen zweiten Temperatur liegt, die niedriger ist als die vorgegebene erste Temperatur; und
wenn festgestellt wird, dass die Einlassgastemperatur die vorgegebene zweite Temperatur überschreitet, Steuern des Durchflussregelventils (48), sodass die Durchflussrate des durch den zweiten Kanal (32b) und den Ladeluftkühler (12) zirkulierenden Kühlmittels zu einer zweiten Kühlmittel-Durchflussrate wird, die kleiner ist als eine Kühlmittel-Durchflussrate, wenn das Durchflussregelventil (48) vollständig geöffnet ist.

6. Das Fahrzeug nach Anspruch 5, wobei, wenn festgestellt wird, dass die Einlassgastemperatur unter der gegebenen zweiten Temperatur liegt, das Steuergerät (62) dazu konfiguriert ist, das Durchflussregelventil (48) so zu steuern, dass es geschlossen wird, wodurch die Durchflussrate des durch den zweiten Kanal (32b) und den Ladeluftkühler (12) zirkulierenden Kühlmittels null wird.

7. Das Fahrzeug nach irgendeinem der vorstehenden Ansprüche, wobei
der erste Kanal (32a) mit den Komponenten (16, 18) verbunden ist, und/oder wobei
der zweite Kanal (32b) mit dem Ladeluftkühler (12) verbunden ist.

8. Das Fahrzeug nach irgendeinem der vorstehenden Ansprüche, wobei
die Komponenten (16, 18) des Motorantriebs (6, 16, 18) Hochspannungskomponenten sind.

## Revendications

1. Un véhicule comprenant :
un moteur (4) présentant un système de recirculation des gaz d'échappement (14), un compresseur d'alimentation (10) et un refroidisseur intermédiaire (*intercooler*) (12) configuré pour refroidir le gaz d'admission contenant le gaz RGE ; et
un dispositif de refroidissement (1, 100),
le dispositif de refroidissement (1, 100) comprenant :
un canal de refroidissement (32) à travers lequel s'écoule un agent de refroidissement d'un entraînement moteur (6, 16, 18), le canal de refroidissement (32) présentant un premier canal (32a) à travers lequel s'écoule un premier agent de refroidissement refroidissant des composants (16, 18) de l'entraînement moteur (6, 16, 18) et un deuxième canal (32b) à travers lequel s'écoule un deuxième agent de refroidissement refroidissant le refroidisseur intermédiaire (12), le deuxième canal (32b) étant ramifié à partir du premier canal (32a) ; et
une vanne (48) fournie au deuxième canal (32b) du canal de refroidissement (32) et configurée pour ajuster un débit (*flow rate*) du deuxième agent de refroidissement,
sachant que
un moteur électrique (6) et les composants (16, 18) constituent l'entraînement moteur (6, 16, 18),
les composants (16, 18) de l'entraînement moteur (6, 16, 18) sont un convertisseur (16) et un onduleur (18),
le premier canal (32a) est un canal où l'agent de refroidissement circule à travers une pompe à eau (46), le convertisseur (16), l'onduleur (18) et le moteur électrique (6), dans cet ordre,
le deuxième canal (32b) est relié au premier canal (32a) à un endroit situé entre les composants (16, 18) et la pompe à eau (46),
le deuxième canal (32b) est configuré pour rejoindre le premier canal (32a) à un endroit situé en aval du moteur électrique (6),
le véhicule comprend en outre un dispositif de commande (62) configuré pour commander la vanne (48),
le dispositif de commande (62) est configuré pour commander la vanne (48) de manière qu'un débit du deuxième agent de refroidissement, lorsqu'une température de gaz d'admission à une sortie du refroidisseur intermédiaire (12) est inférieure à une température donnée, est inférieur à un débit du deuxième agent de refroidissement lorsque la température des gaz d'admission dépasse la température donnée,
le refroidisseur intermédiaire (12) est équipé d'un capteur de température (13) configuré pour détecter la température des gaz d'admission, et que
le capteur de température (13) est configuré pour détecter la température des gaz d'admission à la sortie du refroidisseur intermédiaire (12).

2. Le véhicule d'après la revendication 1, sachant que le dispositif de commande (62) est configuré pour commander la vanne (48) de manière que le débit du deuxième agent de refroidissement devienne nul lorsque la température des gaz d'admission à la sortie du refroidisseur intermédiaire (12) est inférieure à une deuxième température donnée inférieure à la température donnée.

3. Le véhicule d'après l'une quelconque des revendications précédentes, comprenant en outre un autre canal de refroidissement (30) du moteur (4) dans lequel s'écoule l'agent de refroidissement du moteur (4).

4. Le véhicule d'après la revendication 1 ou 2, comprenant en outre un autre canal de refroidissement (30) pour le moteur (4) à travers lequel l'agent de refroidissement pour refroidir le moteur (4) s'écoule, et qui est indépendant du premier canal (32a) et du deuxième canal (32b) du canal de refroidissement (32).

5. Le véhicule d'après l'une quelconque des revendications précédentes, sachant que le dispositif de commande (62) est configuré pour :
déterminer si la température des gaz d'admission à la sortie du refroidisseur intermédiaire (12) est inférieure à une première température donnée ;
lorsque la température des gaz d'admission est déterminée comme étant supérieure à la première température donnée, commander la vanne (48) pour qu'elle s'ouvre complètement ;
lorsque la température des gaz d'admission est déterminée comme étant inférieure à la première température donnée, déterminer si la température des gaz d'admission est inférieure à une deuxième température donnée, inférieure à la première température donnée ; et
lorsque la température des gaz d'admission est déterminée comme étant supérieure à la deuxième température donnée, commander la vanne de régulation de débit (48) de manière que le débit de l'agent de refroidissement, circulant à travers le deuxième canal (32b) et le refroidisseur intermédiaire (12), devienne un deuxième débit d'agent de refroidissement inférieur à un débit d'agent de refroidissement lorsque la vanne de régulation de débit (48) est complètement ouverte.

6. Le véhicule d'après la revendication 5, sachant que, lorsque la température des gaz d'admission est déterminée comme étant inférieure à la deuxième température donnée, le dispositif de commande (62) est configuré pour commander la fermeture de la vanne de régulation de débit (48) de manière que le débit d'agent de refroidissement circulant à travers le deuxième canal (32b) et le refroidisseur intermédiaire (12) devienne nul.

7. Le véhicule d'après l'une quelconque des revendications précédentes, sachant que
le premier canal (32a) est relié aux composants (16, 18), et/ou que
le deuxième canal (32b) est relié au refroidisseur intermédiaire (12).

8. Le véhicule d'après l'une quelconque des revendications précédentes, sachant que
les composants (16, 18) de l'entraînement moteur (6, 16, 18) sont des composants haute tension.
